Europäisches Patentamt

European Patent Office

Office européen des brevets

(19)

(11) Publication number: **0 077 092**
A1

(12) **EUROPEAN PATENT APPLICATION**

(21) Application number: **82201223.3**

(22) Date of filing: **30.09.82**

(51) Int. Cl.³: **H 05 K 3/36,** H 05 K 7/18
// F16B12/02, E04B1/343

(30) Priority: **07.10.81 NL 8104564**

(43) Date of publication of application: **20.04.83**
Bulletin 83/16

(84) Designated Contracting States: **DE FR GB IT NL**

(71) Applicant: **N.V. Philips' Gloeilampenfabrieken,**
**Groenewoudseweg 1, NL-5621 BA Eindhoven (NL)**

(72) Inventor: **Tillemans, Jacobus Hendrikus, c/o INT.**
**OCTROOIBUREAU B.V. Prof. Holstlaan 6, NL-5656 AA**
**Eindhoven (NL)**

(74) Representative: **Cuppens, Hubertus Martinus Maria et al,**
**INTERNATIONAAL OCTROOIBUREAU B.V. Prof.**
**Holstlaan 6, NL-5656 AA Eindhoven (NL)**

(54) **Mounting support for plate-shaped members.**

(57) A mounting support (1) for the mounting of plate-shaped members (3, 5, 39) in two perpendicular planes, comprising at least one U-section channel (7, 9, 11), one of the side walls (7, 9) of which comprises fastening means (13, 15, 17, 21) which engage the plate-shaped members (3, 5, 39).

The mounting support is suitable inter alia for the mounting of ornamental plates, cover plates, wall plates and boards carrying electronic components.

"Mounting support for plate-shaped members".

The invention relates to a mounting support for plate-shaped members which is made of a thermoplastic material and which comprises fastening means for securing to the support at least one plate-shaped member which is to be supported in a first plane and at least one further plate-shaped member which is to be supported in a second plane which extends perpendicularly to the first plane.

A known mounting support of the kind set forth (German Gebrauchsmuster No. 798323) is formed by a frame which comprises fastening means which project from the plane of the frame and which secure the plate-shaped members which are arranged in the second plane and which serve as carriers for electron components in this case. The fact that said fastening means project comparatively far from the plane of the frame in the lateral direction not only leads to a construction having comparatively large dimensions also makes the frame subject to a torsional stress.

It is to be noted that mounting supports are also known in the form of a plastics frame (German Patent Application 2,853,367) whose outer side formed with dovetail-shaped recesses for the mounting of additional components. Such recesses generally are not suitable for the mounting of plate-shaped members such as plate-shaped carriers for electric components.

It is an object of the invention to provide a mounting support in which said drawbacks are avoided.

To this end, the mounting support in accordance with the invention is characterized in that it comprises at least one (first) U-section channel whose transverse cross-section lies in a plane perpendicular to the first plane and the second plane, both side walls of the U-

0077092

section channel being flexible over at least a part of the length of the mounting support, and said fastening means being situated on at least one of the side walls of the (first) U-section channel end being engageable with the relevant plate-shaped members.

An embodiment of the invention which allows for simple mounting of plate-shaped members is characterized in that one side wall of the U-section channel comprises a supporting means for the plate-shaped member which is to be supported in the first plane, said supporting means extending at least partly transversely of the plane of said one side wall and parallel to the longitudinal direction of the mounting support, and said one side wall also comprising a protrusion behind which the plate-shaped member which is to be supported in the first plane can be engaged, the other side wall of the (first) U-section channel comprising a protrusion behind which the plate-shaped member which is to be supported in the second plane can be engaged, and the bottom wall of the (first) U-section channel forming an abutment for the plate-shaped member which is to be supported in the scond plane.

A further embodiment which offers a comparatively large number of mounting possibilities is characterized in that one of the side walls of the first U-section channel forms one side wall of a second U-section channel which is situated within the first U-section channel whose flexible side walls extend parallel to the side walls of the first U-section channel, the other side wall of the second U-section channel comprising a protrusion behind which the plate-shaped member which is to be supported in the second plane can be engaged and a further protrusion behind which can be engaged a further plate-shaped member which is to be supported in a third plane parallel to the second plane.

An embodiment which offers a suitable torsional stiffness is further characterized in that the supporting means for the plate-shaped member which is to be supported in the first plane has an L-shaped cross-section.

A further embodiment which is particularly suitable for use in television apparatus with plate-shaped members in the form of printed-circuit boards carrying electronic components is characterized in that the mounting support is formed as a rectangular frame, the fastening means for at least one plate-shaped member which is to be supported in the first plane being situated on sides of the frame which face one another.

The invention will be described in detail hereinafter with reference to the drawings in which:

Fig. 1 is a plan view of a portion of a first embodiment of a mounting support in accordance with the invention.

Fig. 2 is a transverse sectional view, taken along the line II-II, of the mounting support shown in Fig. 1.

Fig. 3 is a plan view of a portion of a second embodiment of a mounting support in accordance with the invention.

Fig. 4 is a transverse sectional view, taken along the line IV-IV, of the mounting support shown in Fig. 3.

Fig. 5 is a plan view of a portion of a third embodiment of a mounting support in accordance with the invention.

Fig. 6 is a transverse sectional view, taken along the line VI-VI, of the mounting support shown in Fig. 5.

Fig. 7 is a plan view of a fourth embodiment of a mounting support in accordance with the invention.

Fig. 8 is a sectional view, taken along the line VIII-VIII, of the mounting support shown in Fig. 7.

Fig. 9 is a sectional view, taken along the line IX-IX, of the mounting support shown in Fig. 7.

Fig. 10 is a sectional view, taken along the line X-X, of the mounting support shown in Fig. 7.

Fig. 11 is a sectional view, taken along the line XI-XI, of the mounting support shown in Fig. 7.

Fig. 12 is a sectional view, taken along the line XII-XII, of the mounting support shown in Fig. 7.

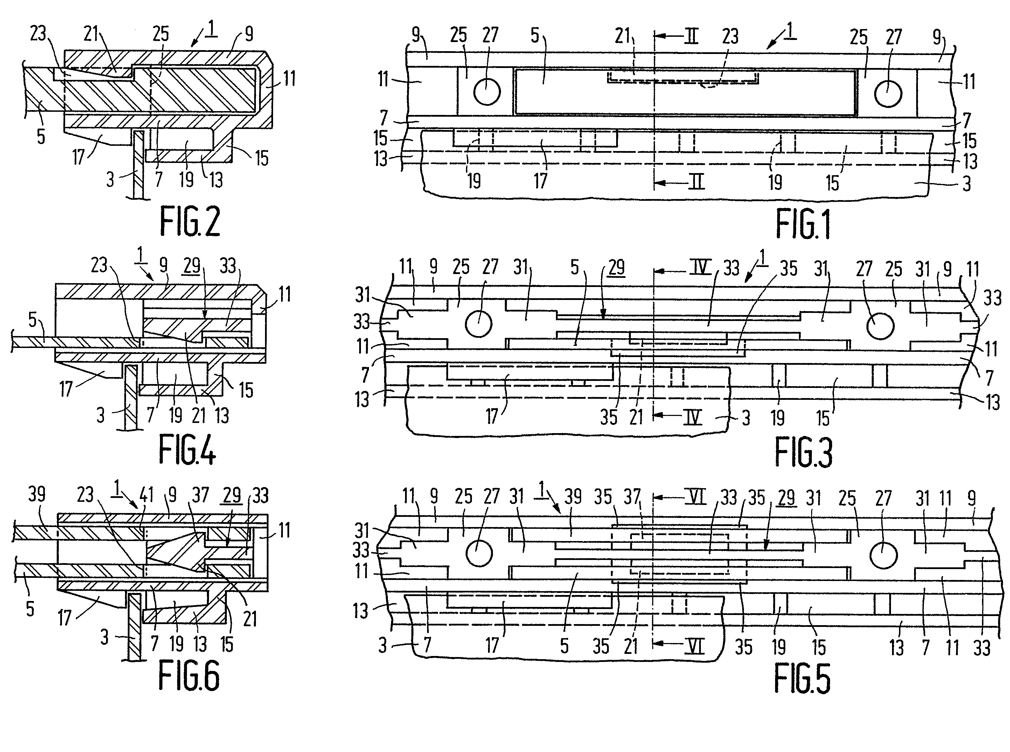

The mounting support 1 which is shown in the Figs. 1 and 2 consists of an integral, elongate moulded product made of, for example, the thermoplastic material acrylonitrile-butadiene-styrene. In a first plane (the plane of the drawing in Fig. 1) there is arranged a plate-shaped member 3. The plate-shaped member 3 may be an ornamentel plate, a cover plate, a wall element etc. In the present case, the plate-shaped member consists of a printed-circuit board. The board 3 is secured to the mounting support 1 by fastening means to be described hereinafter. In a second plane (perpendicular to the plane of the drawing in Figs. 1 and 2) there is arranged a plate-shaped member 5 which consists of a printed-circuit board. The borad 5 is secured to the mounting support 1 by fastening means to be described hereinafter. The boards 3 and 5 serve as carriers for electronic components which have been omitted for the sake of simplicity.

The mounting support 1 comprises a first U-section channel having two parallel side walls 7 and 9 and a bottom wall 11. Parallel to the side wall 7 there extends a further side wall 13 which is connected to the side wall 7 by a bottom wall 15 which extends transversely of the side wall 7. The bottom wall 15 extends parallel to the bottom wall 11. The side wall 7 comprises at least one ramp-shaped protrusion 17 on its outer side, which protrusion engages one side of the board 3 at one edge of the board. The board 3 is located between the protrusion 17 and the side wall 13, which forms a supporting means for the board 3. When the board 3 is held in a clamped manner between the protrusion 17 and the side wall 13, the board 3 may be disposed in a suspended position. With the use of two identical mounting supports rigidly arranged parallel to

one another with the protrusion 17 on each support facing the other support, the board 3 can be secured at two opposite edges. The board 3 can be mounted in the two supports 1 by sliding the board in the longitudinal direction of the supports between the protrusion 17 and the side wall 13 of each support. Alternatively, the board 3 can be engaged behind the protrusions 17 by making the board perpendicularlay to its own plane in a direction perpendicular to the bottom walls 11 and 15. During this movement the side walls 7 are deflected towards the associated side walls 9 by cooperation between the edges of the board 3 and the ramp surfaces of the protrusions 17, so that the board 3 can pass over the protrusions 17. The side walls 7 subsequently snap back to their original positions and the board 3 is retained between the protrusions 17 and the side walls 13. The mounting support 1 may comprise a series of uniformly spaced protrusions 17, so that comparatively large boards 3 or several boards 3 can be mounted. Moreover, boards can then be displaced in the longitudinal direction of the mounting support. In order to give the desired strength to the mounting support 1 while maintaining adequate flexibility of the side wall 7, uniformly spaced transverse webs 19 are formed between the side walls 7 and 13. The side wall 9 comprises at least one ramp-shaped protrusion 21 on its inner side, which protrusion engages the board 5 in a recess 21 in this board. The board 5 is mounted by insertion into the first U-section claimed in a direction perpendicular to the bottom wall 11. During the insertion the side wall 9 is deflected outwards by cooperation between the board 5 and the ramp surface of the protrusion 21, until the protrusion 21 enters the recess 23. The thickness of the board 5 may be larger than that of the board 3. The length of the board 5 (viewed in the longitudinal direction of the mounting support 1) is limited by transverse webs 25 formed between the side walls 7 and 9, which webs serve to reinforce the mounting support 1. In the transverse webs 25 there may be provided holes 27 to receive screws for securing the mounting support 1 against a wall. The mounting support 1 may be provided with a series of uniformly spaced protrusions 21 and transverse webs 25.

Figs. 3 and 4 show another embodiment of a mounting support. The reference numerals in Figs. 3 and 4 correspond to those used in Figs. 1 and 2 wherever possible. The side wall 13, the bottom wall 15 and the protrusions 17 of the embodiment shown in Figs. 3 and 4 are identical to those of the embodiment shown in Figs. 1 and 2. The difference between the two embodiments lies in the location of the protrusion 21 which engages the board 5. The protrusion 21 is formed on one side of a partition 29 which is situated halfway between the side walls 7 and 9 and which extends parallel thereto. In conjunction with a part of the bottom wall 11 and the side wall 9, the partition 29 forms a second U-section channel which is situated within the first U-section channel and which has the side wall 9 in common therewith. The partition 29 extends from one transverse web 25 to another and comprises end portions 31 whose thickness exceeds that of the intermediate portion 33. The bottom wall 11 is provided with an opening 35 opposite the protrusion 21. The opening 35 and the comparatively small thickness of the portion 33 of the partition 29 impart the desired local flexibility to the partition 29. During the insertion of the board 5, the portion 33 of the partition, by cooperation between the board 5 and the ramp surface of the protrusion 21, is deflected towards the side wall 9 until the recess 23 in the board 5 is situated opposite the protrusion 21. The portion 33 of the partition 29 can then return to its original position so that the protrusion 21 enters the recess 23 in the board 5. Because the height of the partition 29 is smaller than the height of the side walls 7 and 9, the part of the first U-section channel which is situated above the partition 29 serves as a guide means for the board 5. The insertion of the board is thus facilitated. Moreover, the part of the first U-section channel which is situated above the partition 29 can be used to accommodate electric cables.

Figs. 5 and 6 show a further embodiment of a mounting support. The reference numerals used in Figs. 5 and 6 correspond to those used in Figs. 1, 2 and 3, 4, wherever possible. The mounting support shown in Figs. 5 and 6 is similar to those shown in Figs. 1 to 4 as far as the side wall 13, the bottom wall 15 and the protrusion 17 are concerned. A difference exists in the first U-section channel. This channel is constructed to be symmetrical at the area of the partition 29 by providing a further ramp-shaped protrusion 37 which is identical to the ramp-shaped protrusion 21. A further printed-circuit board 39 can thus be mounted in the support 1. The board 39 comprises a recess 41 to receive the protrusion 37. For compactness in the drawing, the board 39 is shown situated opposite the board 5 in Figs. 5 and 6. However, this will never be the case in practice, because the mounted board 5 would prevent deflection of the partition 29 towards the side wall 7. Therefore, the boards 5 and 39 actually occupy staggered positions with respect to one another in the longitudinal direction of the mounting support.

It is a common feature of the three embodiments of mounting support shown in Figs. 1-6 that their transverse cross-section includes an L-shaped portion (13, 15). However, this portion is not essential. When a mounting support having a comparatively low torsional stiffness is permitted for given applications, it will suffice to use a mounting support from which the side wall 13 and the transverse webs 19 have been omitted. The bottom wall 15 is then adapted to provide a supporting means for the board 3, for which purpose the wall 15 is situated nearer to the ramp shaped protrusion 17. It is alternatively possible to recess the side wall 13 with respect to the transverse webs 19 which then also serve as a supporting means for the board 3. When a board 3 is mounted in the aforesaid first plane between two parallel mounting supports arranged with the protrusions 17 on each support facing the other support, the side walls 7 and 13 are twisted simultaneously with the deflection of these side walls. The side wall 7 is twisted most. The mounting supports can be supplied in standard lengths which are cut to the desirable length by the user.

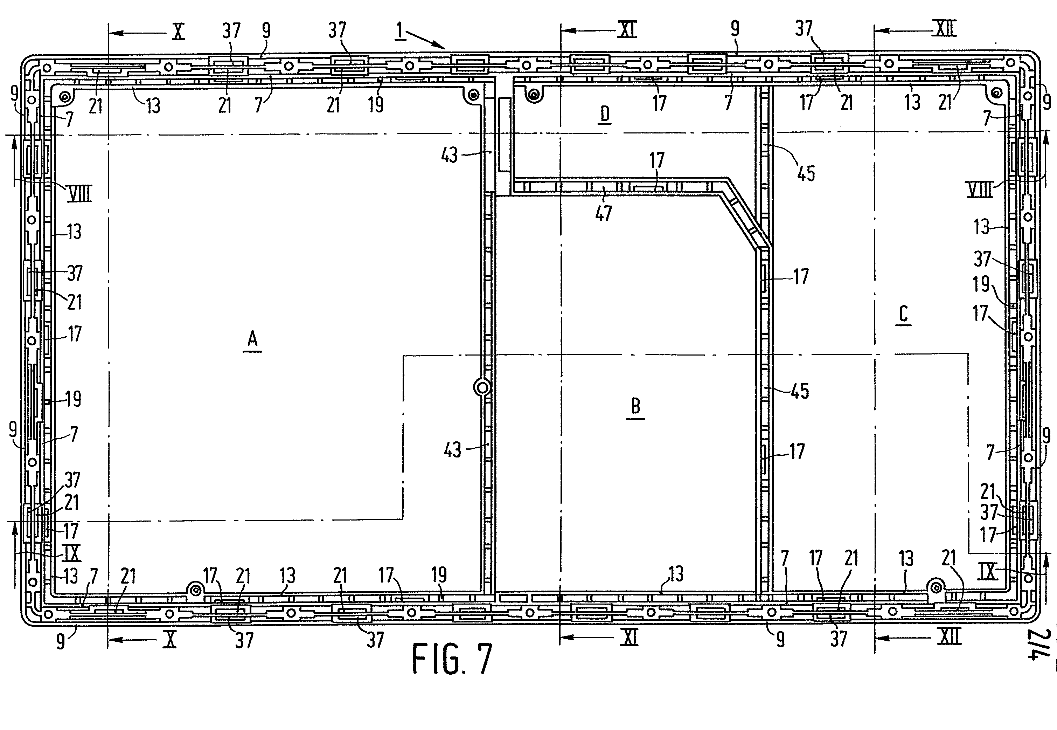

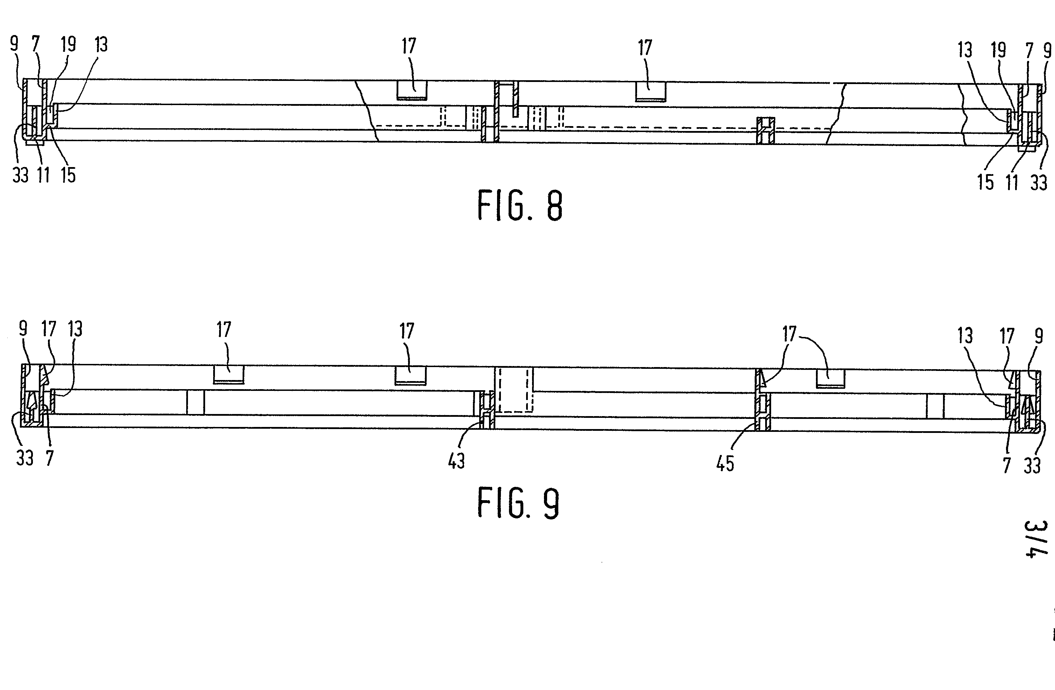

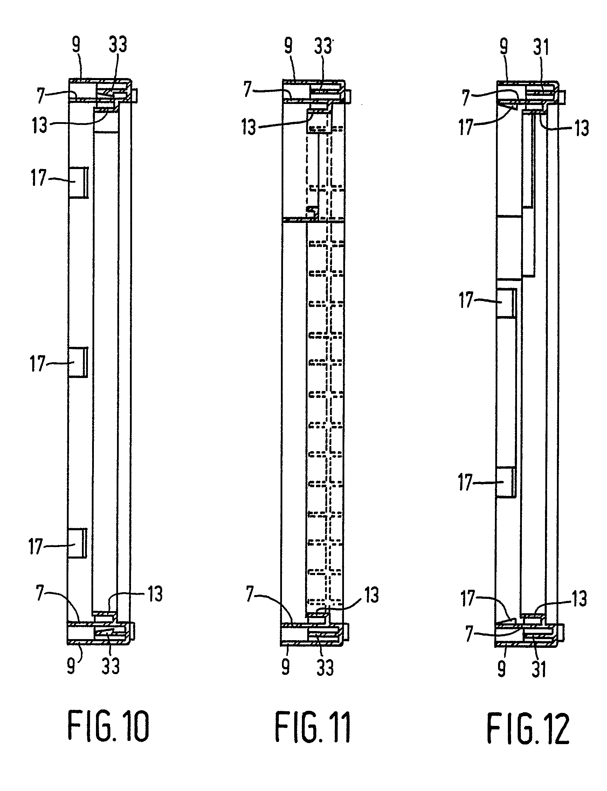

The further embodiment of a mounting support 1 which is shown in the Figs. 7-12 is shaped as a rectangular frame. As shown in Fig. 7, the frame-shaped mounting support 1 consists essentially of an integral rectangular assembly of mounting supports of the construction shown in Figs. 5 and 6. Therefore, for the sake of clarity and convenience reference numerals corresponding to the reference numerals in Figs. 5 and 6 are used in Fig. 7. Four defined areas can be distinguished in the plane of the frame-shaped support 1 (the plane of the drawing), namely, the areas A, B, C and D. The areas A, C and D are intended for the mounting of printed-circuit boards with electronic components. The area B, however, cannot be occupied when the mounting support is used in a television apparatus, because it serves as a passage for the electron gun. The area A is bounded on three sides by mounting supports and on a fourth side (the right-hand side in Fig. 7) by an elongate connecting member 43 which has a transverse cross-section (see Fig. 9)closely resembling that of the previously mentioned L-shaped portion (13, 15) of the transverse cross-section of the mounting supports. The area C is bounded in a similar manner to the area A, the boundary on the fourth side being formed by an elongate connecting member 45 which is similar to the connecting member 43 but which also comprises ramp-shaped protrusions 17 (see also Fig. 9). The area D is bounded by the connecting members 43 and 45 and by a further connecting member 47 which comprises a ramp-shaped protrusion 17 (see also the Figs. 8 and 9). Thus, the area B is bounded on one side by part of the frame and on the remaining three sides by the

connecting members 43, 45 and 47. The relevant printed-circuit boards are mounted in the areas A, C and D by pressing the boards past the ramp-shaped protrusions 17 in a direction perpendicular to the plane of the frame-shaped mounting support (i.e. the plane of the drawing in Fig. 7). The side walls 7 and 13 are twisted during this operation. In practice it often occurs that additional printed-circuit boards with electronic components have to be added. This may be due to differences in the customers' requirements or to the fact that adaptations have to be made or additional functions incorporated in the apparatus. For a television such an addition may concern, for example, a teletext facility. The first U-section channel, which extends along the circumference of the frame-shaped mounting support, allows for the addition of many extra functions to an apparatus by the mounting of boards with electronic components in a second plane and a third plane which extend perpendicularly to the plane of the areas A, B, C and D. Additions of this kind require a comparatively small amount of space in the lateral direction (in the plane of the drawing in Fig. 7), because the fastening means for the additional boards are integrated in the first U-shaped trough.

The bar-shaped as well as the frame-shaped embodiments of the mounting supports according to the invention offer numerous possibilities for the mounting of boards with electronic components in a variety of electronic apparatuses. The supports, moreover, can also be used for the formation of walls, ceilings, partitions etc., by the mounting of a variety of plates or boards. This is because the fastening means of the mounting supports generally are particularly suitable for the mounting of plate-shaped members. The materials to be used for the described mounting supports are limited to thermoplastic materials, because the flexibility and the twistability of the supports are of great importance.

0077092

1.       A mounting support (1) for plate-shaped members (3, 5, 39) which is made of a thermoplastic material and which comprises fastening means (13, 15, 17, 21, 23) for securing to the support at least one plate-shaped member (3) which is to be supported in a first plane and at least one further plate-shaped member (5) which is to be supported in a second plane which extends perpendicularly to the first plane, characterized in that said mounting support (1) comprises at least one (first) U-section channel (7, 9, 11) whose transverse cross-section lies in a plane perpendicular to the first plane and the second plane, both side walls (7, 9) of the U-section channel (7, 9, 11) being flexible over at least a part of the length of the mounting support (1), and said fastening means (13, 15, 17, 21) being situated on at least one of the side walls (7, 9) of the (first) U-section channel (7, 9, 11) and being engageable with the relevant plate-shaped members (3, 5).

2.       A mounting support as claimed in Claim 1, characterized in that one side wall (7) of the (first) U-section channel (7, 9, 11) comprises a supporting means (13, 15) for the plate-shaped member (3) which is to be supported in the first plane, said supporting means extending at least partly transversely of the plane of said one side wall (7) and parallel to the longitudinal direction of the mounting support (1) and said one side wall also comprising a protrusion (17) behind which the plate-shaped member (3) which is to be supported in the first plane can be engaged, the other side wall (9) of the (first) U-section channel (7, 9, 11) comprising a protrusion (21) behind which the plate-shaped member (5) which is to be supported in the second plane can be engaged, and the bottom wall (11) of the (first) U-section channel (7, 9, 11) forming an abutment for the plate-shaped member (5) which is to be supported in the second plane.

3.          A mounting support as claimed in Claim 1 or 2, characterized in that one of the side walls (9) of the first U-section channel (7, 9, 11) forms one side wall of a second U-section channel (9, 11, 29) which is situated within the first U-section channel (7, 9, 11) and whose flexible side walls (9, 29) extend parallel to the side walls of the first U-section channel (7, 9, 11), the other side wall (29) of the second U-section channel (9, 11, 29) comprising a protrusion (21) behind which the plate-shaped member (5) which is to be supported in the second plane can be engaged and a further protrusion (37) behind which can be engaged a further plate-shaped member (39) which is to be supported in a third plane parallel to the second plane.

4.          A mounting support as claimed in Claim 2, characterized in that the supporting means (13, 15) for the plate-shaped member (3) which is to be supported in the first plane has an L-shaped cross-section.

5.          A mounting support as claimed in Claim 1, characterized in that the mounting support (1) is formed as a rectangular frame, the fastening means (13, 15, 17) for at least one plate-shaped member (3) which is to be supported in the first plane being situated on sides of the frame which face one another.

6.          A mounting support for plate-shaped carriers as described in any of the preceding claims.

FIG.2

FIG.1

FIG.4

FIG.3

FIG.6

FIG.5

1-IV-PHN 10171

0077092

FIG. 7

9 7 19 13                         17                    17                    13 19 7 9

**FIG. 8**

33 11 15                                                              15 11 33

9 17 13                    17          17                    17           13 17 9

33 7                    43              45                    7 33

**FIG. 9**

0077092

FIG.10　　　FIG.11　　　FIG.12

# EUROPEAN SEARCH REPORT

European Patent Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| | --- | | H 05 K    3/36 |
| A | FR-A-1 016 352   (G.G. LEIBOVITCH) | | H 05 K    7/18 // |
| | | | F 16 B   12/02 |
| | --- | | E 04 B    1/343 |
| A | DE-B-1 298 440   (HOLZWERTE AG) | | |
| | --- | | |
| A | DE-A-2 008 785   (XAVER FREDE MÖBELFABRIK) | | |
| | --- | | |
| A | DE-A-1 935 283   (SCHMIDT A) | | |
| | ----- | | |

### TECHNICAL FIELDS SEARCHED (Int. Cl. 3)

H 05 K
F 16 B
E 04 B
B 65 D

The present search report has been drawn up for all claims

| Place of search | Date of completion of the search | Examiner |
|---|---|---|
| THE HAGUE | 13-01-1983 | SCHUERMANS N.F.C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82